# EUROPEAN PATENT APPLICATION

(11) **EP 1 968 107 A1**
(43) Date of publication of application: **10.09.2008**
(21) Application number: 06833034.9
(22) Date of filing: 21.11.2006
(51) Int. Cl.: H01L 21/52, B23K 1/00, B23K 3/00, H01L 25/07, H01L 25/18, H05K 3/34

(54) **SOLDERING METHOD AND SEMICONDUCTOR MODULE MANUFACTURING METHOD**

(30) Priority: 28.12.2005 JP 2005380352
(71) Applicant: KABUSHIKI KAISHA TOYOTA JIDOSHOKKI, Kariya-shi, Aichi 448-8671 (JP)
(72) Inventor: KIMBARA, Masahiko, Kariya-shi, Aichi 4488671 (JP)
(74) Representative: TBK-Patent
(86) International application number: PCT/JP2006/323184
(87) International publication number: WO 2007/077688

(57) **Abstract**

A soldering method for soldering a semiconductor element to each of bonding portions defined at a plurality of locations on a circuit board is disclosed. The soldering method includes laying out the bonding portions in a non-linear manner in at least three locations on the circuit board, placing the semiconductor elements on the bonding portions with solder in between, placing a weight on the at least three semiconductor elements, which are laid out in a non-linear manner, so that the weight extends over the semiconductor elements, and soldering the semiconductor elements to the bonding portions by melting the solder while pressurizing the semiconductor elements with the weight. This reduces variations in thickness of the solder at the plurality of bonding portions when soldering the plurality of semiconductor elements to the circuit board.

## Description

### TECHNICAL FIELD

The present invention relates to a soldering method for soldering a plurality of semiconductor elements on a circuit board, and a semiconductor module manufacturing method.

### BACKGROUND ART

When connecting semiconductor elements and electronic components to a circuit board, solder is normally used to bond the circuit board and the semiconductor element and the like. When soldering the semiconductor element or the like on the circuit board, the semiconductor elements and the like may be displaced by surface tension of the melted solder. In other cases, when solder melts between the semiconductor elements and the like and the circuit board, the semiconductor elements and the like may be bonded without the solder spreading entirely over bonding surfaces of the semiconductor elements and the like. Patent documents 1, 2, 3, and 4 disclose examples of methods proposed to prevent such problems. Patent documents 1 and 2 propose a method for pressurizing a semiconductor element with a weight arranged on the semiconductor element when a solder bump reflow process is performed to solder a semiconductor element to a circuit board.

Patent document 3 discloses a method employing a triple-layer solder. The triple-layer solder includes a first solder layer formed from a high melting point material. A second solder layer, which is arranged on each of opposite sides of the first solder layer, is formed from a material having a melting point that is lower than that of the first solder layer. The triple-layer solder is arranged between a semiconductor element and a support holding the semiconductor element. A weight applies pressure to the triple-layer solder. Heating and thermal processing are performed to melt only the second solder layers and bond the semiconductor element to the support.

Patent document 4 proposes a method for stably soldering a component A and a component B in an accurate positional relationship. This soldering method includes a process of positioning and holding the component A on a transport jig with a component holding member fixed to a transport jig base, a process of positioning and holding an upper jig with an upper jig positioning member fixed to the transport jig base, a process of holding the component B with a weight positioned and held on the upper jig in a vertically movable manner, and a process of heating the component A and the component B in a state in which they face toward each other with solder arranged in between to perform soldering.

In the methods disclosed in patent documents 1, 2, 3, and 4, a weight is arranged on a semiconductor element, which is the component that is soldered, during soldering. This aids the spreading of the solder. In methods using a solder bump as in patent documents 1 and 2, a single semiconductor element is in contact with molten solder at a plurality of locations. Thus, the weight on the semiconductor element stably presses (pressurizes) the semiconductor element towards the substrate.

However, the problems described below may arise when melting the solder that is in correspondence with the entire bonding surface of the semiconductor element as in patent document 3. Depending on the type of the solder, the surface of the solder facing towards the semiconductor element may become convex due to surface tension when the solder melts. This may tilt the weight on the semiconductor element and cause the thickness of the solder between the semiconductor element and the support to become uneven.

A coolant circuit board, in which a ceramic substrate and a metal heat sink are formed integrally, may be used as the circuit board. In such a case, if the thickness of solder varies at bonding portions for the plurality of semiconductor elements and the circuit board, this would result in a varied heat resistance. Further, solder has a stress alleviating effect that absorbs the difference in the linear expansion rates of the semiconductor element, which is bonded by the solder, and a wiring layer formed on the circuit board. However, if the heat resistance varies at the plurality of bonding portions, the stress alleviating effect of the solder would vary between the plurality of bonding portion. This would vary the fatigue life in different bonding portions.

Thus, a guide (positioning member) for preventing tilting of the weight must be used as in patent document 4. However, in a semiconductor module formed by soldering a plurality of semiconductor elements to a circuit board, the structure would be complicated if a guide is provided for each of the weights arranged on the plurality of semiconductor elements. This would also increase the soldering operations.
[Patent Document 1] Japanese Laid-Open Patent Publication No. 11-260859
[Patent Document 2] Japanese Laid-Open Patent Publication No. 2000-332052
[Patent Document 3] Japanese Laid-Open Patent Publication No. 6-163612
[Patent Document 4] Japanese Laid-Open Patent Publication No. 2001-121259

### DISCLOSURE OF THE INVENTION

It is an object of the present invention to provide a soldering method and a semiconductor module manufacturing method that prevents variations in solder thickness at a plurality of bonding portions when soldering a plurality of semiconductor elements on a circuit board.

To achieve the above object, the present invention provides a soldering method for soldering a semiconductor element to each of bonding portions defined at a plurality of locations on a circuit board. The soldering method includes laying out the bonding portions in a non-linear manner in at least three locations on the circuit board, placing the semiconductor elements on the bonding portions with solder in between, placing a weight on the at least three semiconductor elements, which are laid out in a non-linear manner, so that the weight extends over the semiconductor elements, and soldering the semiconductor elements to the bonding portions by melting the solder while pressurizing the semiconductor elements with the weight.

A further aspect of the present invention provides a semiconductor module manufacturing method including a circuit board, and a semiconductor element soldered to each of bonding portions defined at a plurality of locations on the circuit board. The manufacturing method includes laying out the bonding portions in a non-linear manner in at least three locations on the circuit board, placing the semiconductor elements on the bonding portions with solder in between, placing a weight on the at least three semiconductor elements, which are laid out in a non-linear manner, so that the weight extends over the semiconductor elements, and soldering the semiconductor elements to the bonding portions by melting the solder while pressurizing the semiconductor elements with the weight.

### BRIEF DESCRIPTION OF THE DRAWINGS

Fig. 1 is a plan view of a semiconductor module including one ceramic substrate according to the present invention;
Fig. 2 is a cross-sectional view taken along line 2-2 in Fig. 1;
Fig. 3 is a plan view showing a semiconductor module including a plurality of ceramic substrates;
Fig. 4(a) is a plan view showing a jig used for soldering, and Fig. 4(b) is a perspective view showing a weight used for soldering;
Fig. 5 is a schematic, vertical cross-sectional view of a soldering device in a first embodiment for performing soldering on the semiconductor module of Fig. 3;
Fig. 6 is a vertical cross-sectional view of a soldering device according to a second embodiment of the present invention;
Fig. 7 is a partial cross-sectional view of a soldering device in another embodiment; and
Fig. 8(a) is a schematic plan view showing the layout of semiconductor elements and the shape of weights in a further embodiment, and Fig. 8(b) is a plan view showing a support plate.

### BEST MODE FOR CARRYING OUT THE INVENTION

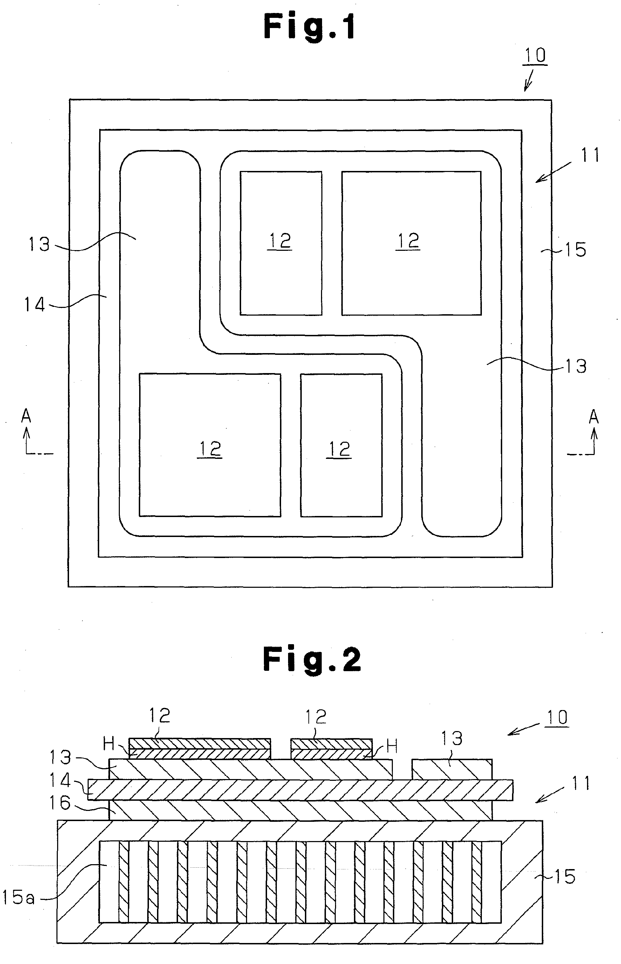

A first embodiment of the present invention will now be discussed with reference to Figs. 1 to 5.

A semiconductor module 10 includes a circuit board 11, and at least three semiconductor elements 12, which are laid out in a non-linear manner, on the circuit board 11. The semiconductor module 10 shown in Figs. 1 and 2 includes four semiconductor elements 12. The circuit board 11 includes a ceramic substrate 14, which serves as a ceramic insulator and has a surface with a metal circuit 13 laid out thereon, and a metal heat sink 15, which is fixed to the ceramic substrate 14 by means of a metal plate 16. The circuit board 11 is a cooling circuit board, that is, a circuit board incorporating a heat sink. The heat sink 15, which is formed from an aluminum metal, copper, or the like, includes a cooling medium passage 15a through which a cooling medium flows. An aluminum metal includes aluminum and aluminum alloys. The metal plate 16, which functions as a bonding layer for bonding the ceramic substrate 14 and the heat sink 15, is formed from aluminum, copper, or the like.

The metal circuit 13 is formed from aluminum, copper, or the like. The ceramic substrate 14 is formed from aluminum nitride, alumina, silicon nitride, or the like. The semiconductor element 12 is bonded (soldered) to the metal circuit 13. In other words, the metal circuit 13 defines a bonding portion for bonding the semiconductor elements 12 to the circuit board 11. Reference character "H" in Fig. 2 denotes a solder layer. The semiconductor elements 12 may be an IGBT (Insulated Gate Bipolar Transistor) or a diode.

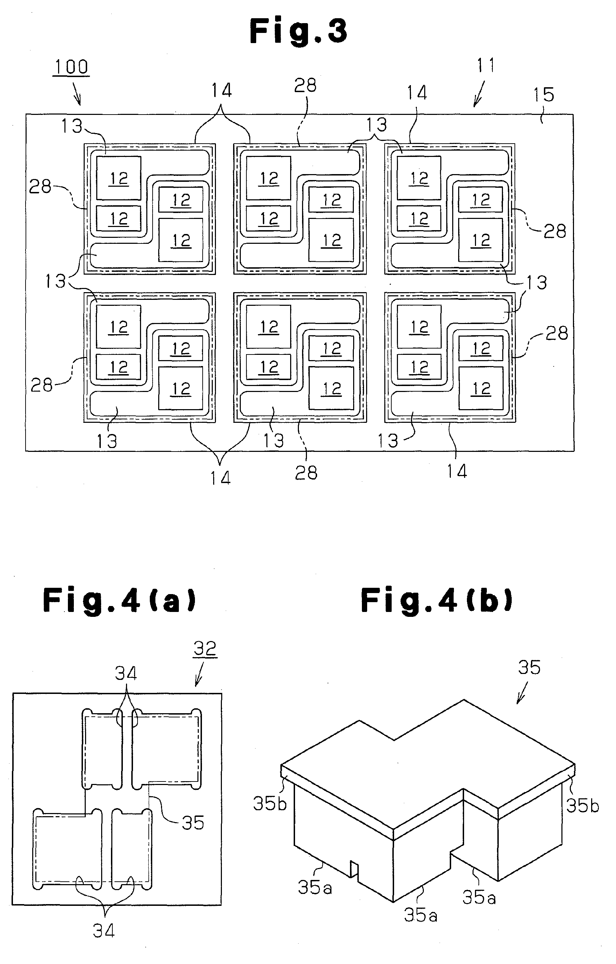

The semiconductor module 10 is not limited to those with a structure that include a circuit board 11 formed by integrating a single ceramic substrate 14 with the heat sink 15. For example, as shown in Fig. 3, a semiconductor module 100 may including a circuit board 11 formed by fixing a plurality of (six in this embodiment) ceramic substrates 14, each having a surface with a metal circuit 13, to a heat sink 15. In the semiconductor module 100, four semiconductor elements 12 are soldered to each ceramic substrate 14. Thus, the semiconductor module 100 has a total of twenty-four semiconductor elements 12.

A method for manufacturing a semiconductor module will now be described.

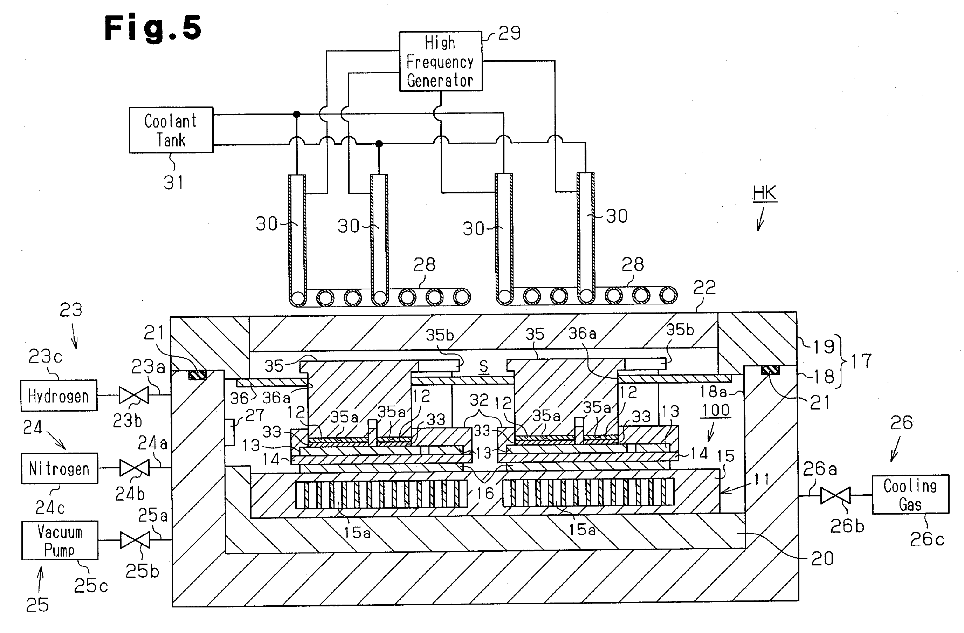

Fig. 5 schematically shows the structure of a soldering device HK. The soldering device HK is a device for soldering the semiconductor elements 12 to the metal circuits 13 on the circuit boards 11. The soldering device HK of this embodiment is a soldering device for the semiconductor module 100 shown in Fig. 3, that is, the semiconductor module 100 that includes the plurality of (six) ceramic substrates 14 on the heat sink 15.

The soldering device HK includes a sealable container (chamber) 17. The container 17 includes a box-shaped main body 18, which has an opening 18a, and a cover body 19, which opens and closes the opening 18a of the main body 18. A support base 20 for positioning and supporting the semiconductor module 100 is arranged in the main body 18. A packing 21, which comes in contact with the cover body 19, is arranged in the open end of the main body 18.

The cover body 19 is large enough to close the opening 18a of the main body 18. A sealed space S is formed in the container 17 by attaching the cover body 19 to the main body 18. The cover body 19 has a portion 22 facing towards the sealed space S. The portion 22 is formed from an electric insulation material allowing the passage of magnetic lines of force (magnetic flux). In this embodiment, glass is used as the electric insulation material, and the portion 22 of the cover body 19 is made of glass plate.

A reducing gas supply unit 23 for supplying reductive gas (hydrogen in this embodiment) into the container 17 is connected to the main body 18. The reducing gas supply unit 23 includes a pipe 23a, an open/close valve 23 arranged in the pipe 23a, and a hydrogen tank 23c. An inert gas supply unit 24 for supplying inert gas (nitrogen in this embodiment) into the container 17 is also connected to the main body 18. The inert gas supply unit 24 includes a pipe 24a, an open/close valve 24b arranged in the pipe 24a, and a nitrogen tank 24c. A gas discharge unit 25 for discharging gas out of the container 17 is connected to the main body 18. The gas discharge unit 25 includes a pipe 25a, an open/close valve 25b arranged in the pipe 25a, and a vacuum pump 25c. The soldering device HK adjusts the pressure in the sealed space S with the reducing gas supply unit 23, the inert gas supply unit 24, and the gas discharge unit 25 to pressurize or depressurize the sealed space S.

A supply unit 26 for supplying heat medium (cooling gas) into the container 17 subsequent to soldering is connected to the main body 18. The heat medium supply unit 26 includes a pipe 26a, an open/close valve 26b arranged in the pipe 26a, and a gas tank 26c. The heat medium supply unit 26 supplies the cooling gas to the heat sink 15 of the semiconductor module 100 accommodated in the container 17. The heat medium supplied from the heat medium supply unit 26 may be a cooling liquid. A temperature sensor (e.g., thermocouple etc.) 27 for measuring the temperature in the container 17 is arranged on the main body 18.

A plurality of high frequency heating coils 28 are arranged at the upper part of the soldering device HK, specifically, at the upper side of the cover body 19. The soldering device HK of the embodiment includes six high frequency heating coils 28. Referring to Fig. 3, the high frequency heating coils 28 are arranged above the ceramic substrates 14 at positions respectively corresponding to the six ceramic substrates 14. In this embodiment, each heating coil 28 is large enough to cover a single ceramic substrate 14 and larger than the contour of an upper surface of a weight 35, which will be described later, when viewed from the upper side. Each high frequency heating coil 28 is spirally wound along the same plane (polygonal spiral winding) and as a whole has the shape of a substantially tetragonal plate. Each high frequency heating coil 28 is arranged so as to face the cover body 19, specifically, so as to face the glass plate 22. Furthermore, each high frequency heating coil 28 is electrically connected to a high frequency generator 29 arranged in the soldering device HK. The output of the high frequency generator 29 is controlled based on the measurements of the temperature sensor 27 arranged in the container 17. Each high frequency heating coil 28 includes a coolant path 30, through which coolant flows, and is connected to a coolant tank 31 arranged in the soldering device HK.

Fig. 4(a) shows a jig 32 used for soldering, and Fig. 4(b) shows a weight 35 serving as a pressurizing body. The jig 32 has the shape of a flat plate and has the same size as the ceramic substrate 14 in the circuit board 11. The jig 32 is formed from a material such as graphite or ceramic. As shown in Fig. 5, during soldering, the jig 32 is used to position the solder sheets 33, the semiconductor elements 12, and the weights 35 on the ceramic substrate 14. For this reason, a plurality of positioning holes 34 extend through the jig 32. The holes 34 are formed in the jig 32 in correspondence with the portion (bonding portion) on the ceramic substrate 14 to which the semiconductor elements 12 are bonded. Each hole 34 has a size that is in correspondence with the size of the associated semiconductor element 12. In this embodiment, a plurality of (four) semiconductor elements 12 are bonded to the ceramic substrate 14. Thus, a plurality of (four) holes 34 are formed in the jig 32.

The weight 35 is formed from a material that generates heat through an electromagnetic induction effect, that is, material that generates heat by means of its electric resistance when current is generated by changes in the magnetic flux passing therethrough. In this embodiment, the weight 35 is formed from stainless steel. During soldering, the weight 35 is arranged on the four semiconductor elements 12, which are positioned by the jig 32, and is sized so that it contacts the upper surfaces (non-bonding surfaces) of the four semiconductor elements 12. That is, the weight 35 is sized so that it extends over at least three semiconductor elements 12, which are laid out in a non-linear manner.

As shown in Fig. 4(a) and Fig. 4(b), the weight 35 includes a pressurizing surface shaped in correspondence with the layout of the four semiconductor elements 12 on the side that contacts the four semiconductor elements 12 during soldering. In the present embodiment, the pressurizing surface of the weight 35 is divided into four pressurizing surfaces 35a, which are shaped to be insertable into the four holes of the jig 32 and contactable with the corresponding semiconductor elements 12. The weight 35 has a flange 35b serving as a hook at the opposite side of the pressurizing surface 35a. Fig. 4(a) indicates the contour of the weight 35 on the pressurizing surface 35a with the double-dotted lines and shows the positional relationship of the jig 32 and the weight 35 when the weight 35 is inserted into the holes 34 of the jig 32.

In this embodiment, the soldering device HK is configured so that the weights 35 are all movable between positions enabling pressurizing of the semiconductor element 12 and positions separated from the semiconductor elements 12. Specifically, as shown in Fig. 5, a support plate 36 for supporting the weights 35 is horizontally attached to the cover body 19. The support plate 36 is formed from an insulative material (e.g., ceramics) that passes magnetic lines of force and includes holes 36a, the quantity of which corresponds to the quantity of the weights 35, to allow insertion of the weights 35 at portions lower than the flange 35b. When the cover body 19 is attached to the main body 18, the holes 36a are located at positions facing toward the bonding portion (metal circuit 13) of the circuit board 11, which is positioned on the support base 20. Each weight 35 is supported by the support plate 36 in a state fitted into the corresponding hole 36a. As shown in Fig. 5, in a state in which the cover body 19 is arranged at the closed position, the pressurizing surfaces 35a of each weight 35 contacts the non-bonding surfaces of the corresponding semiconductor elements 12. Further, the flange 35b is lifted from the upper surface of the support plate 36. Thus, the weight 35 pressurizes the semiconductor elements 12 with its own weight.

A process for soldering the semiconductor elements 12 with the soldering device HK will now be described. The soldering process is one process performed when manufacturing the semiconductor module 100. Before performing soldering with the soldering device HK, a subject (hereinafter referred to as "soldering subject") in which a plurality of (six) ceramic substrates 14 including the metal circuits 13 are bonded to a heat sink 15 is prepared in advance. In other words, the soldering subject corresponds to the semiconductor module 100 shown in Fig. 3 less the semiconductor elements 12.

When performing soldering, first, the cover body 19 is removed from the main body 18 to open the opening 18a. A soldering subject is then arranged on the support base 20 of the main body 18 and positioned relative to the support base 20, as shown in Fig. 5. A jig 32 is then placed on each ceramic substrate 14 of the soldering object. Further, a solder sheet 33 and a semiconductor element 12 are arranged in each hole 34 of the jig 32. The solder sheet 33 is arranged between the metal circuit 13 and the semiconductor element 12.

The cover body 19 is then attached to the main body 18 to close the opening 18a. This forms the sealed space S in the container 17. When the cover body 19 is attached to the main body 18, the portion of each weight 35 located at the side of the pressurizing surfaces 35a is inserted into the corresponding hole 34 of the associated jig 32, as shown in Fig. 5. As a result, the pressurizing surfaces 35a contact the non-bonding surfaces, that is, the upper surfaces of the corresponding semiconductor elements 12, and the flange 35b becomes spaced apart from the support plate 36. Each weight 35 is arranged to pressurize the corresponding semiconductor elements with its weight while extending over the four semiconductor elements 12. In this state, the solder sheets 33, the semiconductor elements 12, and the weight 35 are arranged in an overlapping manner from the metal circuit 13 on each ceramic substrate 14.

In a state in which the circuit board 11, the solder sheets 33, the semiconductor elements 12, and the weights 35 are accommodated in the sealed space S, the plurality of high frequency heating coils 28 are arranged above the corresponding weights 35. The glass plate 22 attached to the cover body 19 is arranged between the high frequency heating coils 28 and the corresponding weights 35. In this embodiment, the high frequency heating coils 28 are each configured and arranged so that the high frequency heating coil 28 extends out of region defined by the contour of the upper surface of the corresponding weight 35 when viewing the high frequency heating coil 28 from above. In this embodiment, a large amount of magnetic flux is generated near the central part of the high frequency heating coil 28, which is spirally wound. Thus, it is preferable that the weight 35 be arranged near the central part of the high frequency heating coil 28.

Next, the gas discharge unit 25 is operated to depressurize the container 17. Further, the inert gas supply unit 24 is operated to supply the container 17 with nitrogen and fill the sealed space S with inert gas. After repeating the depressurization and supplying of nitrogen a few times, the reducing gas supply unit 23 is operated to supply hydrogen into the container 17 and produce a reducing gas atmosphere in the sealed space S.

The high frequency generator 29 is then operated to generate high frequency current that flows to each high frequency heating coil 28. As a result, the high frequency heating coil 28 generates high frequency magnetic flux passing through the corresponding weight 35, and the magnetic flux generates eddy current passing through the weight 35. This produces an electromagnetic induction effect that heats the weight 35, which is arranged in the magnetic flux of the high frequency heating coil 28. The heat is then transmitted from the pressurizing surfaces 35a of the weight 35 to the semiconductor elements 12. The heat generated in the weight 35 is transmitted in a concentrated manner to the solder sheets 33 arranged on each bonding portion of the circuit board 11 through the pressurizing surfaces 35a of the weight 35 and the semiconductor elements 12. This heats the solder sheets 33. As a result, the temperature of the solder sheets 33 rises and becomes higher than or equal to its melting point. This melts the solder sheets 33.

Each semiconductor element 12 is pressurized towards the circuit board 11 by the corresponding weight 35. Thus, the surface tension of the molten solder does not move the semiconductor element 12. When the solder sheets 33 completely melt, the high frequency generator 29 is deactivated. The level of the high frequency current flowing to the high frequency heating coils 28 is controlled based on the detection results of the temperature sensor 27, which is arranged in the container 17. The atmosphere adjustment of the space (sealed space S) in the container 17, that is the pressurization and depressurization of the container 17 (sealed space S) is performed in accordance with the progress in the soldering.

After the solder sheets 33 completely melt, the heat medium supply unit 26 is operated to supply cooling gas into the container 17. The cooling gas is blasted towards an inlet or outlet of the cooling medium passage 15a in the heat sink 15. The cooling gas supplied into the container 17 flows through the cooling medium passage 15a and around the heat sink 15 to cool the soldering subject. The molten solder solidifies as it cools and its temperature becomes lower than the melting point. This bonds the metal circuit 13 and the semiconductor elements 12. In this state, the soldering is terminated, and the semiconductor module 100 is completed. Then, the cover body 19 is removed from the main body 18, and the semiconductor module 100 is taken out from the container 17 after removing the jigs 32.

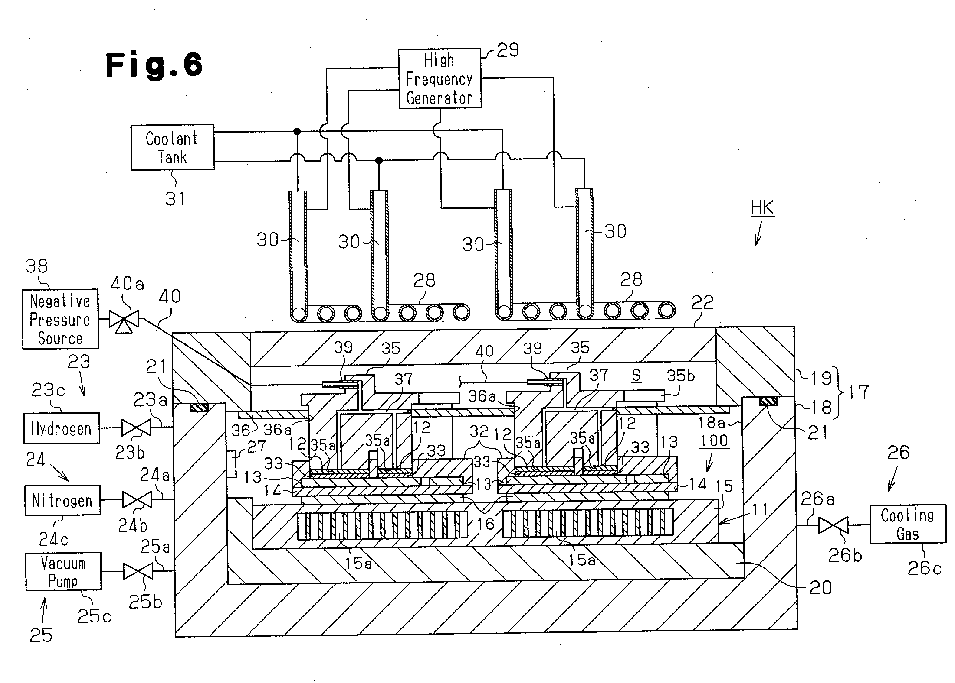

The embodiment has the advantages described below.
(1) When soldering the semiconductor elements 12 to the bonding portions (metal circuits 13) on the circuit board 11 during the soldering process, the semiconductor elements 12 are arranged on each metal circuit 13 by means of the solder, and each weight 35 is arranged on the semiconductor elements 12 in a state extending over at least three semiconductor elements 12, which are laid out in a non-linear manner. The solder is heated and melted in a state in which each semiconductor element 12 pressurized towards the circuit board 11 by the corresponding weight 35. Therefore, when the solder melts, the weight 35 pressurizes the corresponding semiconductor elements 12 towards the bonding surface in a horizontal state or in a substantially horizontal state. This would not happen if each weight 35 were to be arranged on only one semiconductor element 12. Thus, when molten solder between the semiconductor elements 12 and the corresponding metal circuit 13 solidifies as it is cooled to a temperature lower than or equal to the melting point temperature, the thickness of the solder at each bonding portion does not become uneven. Further, molten solder spreads entirely over surfaces facing toward the metal circuits 13 of the semiconductor element 12.
(2) The weights 35 includes the pressurizing surface 35a that are shaped in correspondence with the contours of the associated semiconductor elements 12, and the pressurizing surfaces 35a entirely pressurize the associated semiconductor elements 12. Accordingly, uniform pressure is applied to the plurality of semiconductor elements 12 and variations in the thickness of the solder at the plurality of bonding portions are further minimized.
(3) The semiconductor modules 10 and 100 each include the circuit board 11, which serves as a cooling circuit board. The circuit board 11 is formed by fixing one or more ceramic substrates 14 having surfaces on which the metal circuits 13 are arranged to the metal heat sink 15 including the cooling medium passage 15a. Solder extends entirely over the surface of each semiconductor element 12 facing towards the corresponding metal circuit 13 and solidifies with an even thickness. Accordingly, in the semiconductor modules 10 and 100, the solder functions to alleviate stress in a satisfactory manner so as to absorb the difference in linear expansion rates between the semiconductor elements 12 and the metal circuits 13. This minimizes variations in fatigue life of the bonding portions.
(4) In the circuit board 11 that includes the plurality of ceramic substrates 14, at least three semiconductor elements 12 are arranged on each ceramic substrate 14. The semiconductor elements 12 are laid out in a non-linear manner. One weight 35 is arranged for each ceramic substrate 14 in a state extending over the semiconductor elements 12. The weights 35 are all simultaneously arranged at predetermined positions for contacting and pressurizing the semiconductor elements 12 and simultaneously arranged at positions separated from the semiconductor elements 12. Accordingly, even though there is a plurality of the weights 35, the weights 35 are efficiently moved between the predetermined positions and the positions separated from the predetermined positions.
(5) Each weight 35 includes the flange 35b, or a hook, on the opposite side of the pressurizing surfaces 35a. The weight 35 is inserted into one of the holes 36a of the support plate 36 attached to the cover body 19, and the lower surface of the flange 35b is supported by the support plate 36 in a state engaging the upper surface of the support plate 36. In a state in which the cover body 19 is attached to the main body 18, the holes 36a are formed at positions facing toward the metal circuit 13 on the circuit board 11, which is positioned relative to the support base 20. Accordingly, when the cover body 19 is attached to the main body 18, the weights 35 are automatically arranged at positions facing toward the semiconductor elements 12. When the cover body 19 is removed from the main body 18, the weights 35 are automatically moved to positions separated from the semiconductor elements 12.
(6) The solder sheets 33 and the semiconductor elements 12 are positioned at predetermined positions on the ceramic substrate 14 by the jigs 32. Accordingly, when the weights 35 are attached to the support plate 36 as described above, the weights 35 are accurately and efficiently arranged at positions for contact with the semiconductor elements 12.
(7) The weights 35 for pressurizing the semiconductor elements 12 generate heat through induction heating, and the solder sheets 33 arranged between the semiconductor elements 12 and the metal circuit 13 are heated by the semiconductor elements 12. Thus, heat is transmitted in a concentrating manner to the solder sheets 33. Accordingly, the solder sheets 33 are efficiently heated in comparison to when entirely heating the circuit board 11 or entirely heating the container 17.
(8) The high frequency heating coil 28 is arranged above the weight 35 arranged immediately above the semiconductor element 12. Thus, the high frequency heating coil 28 planarly transmits heat to a plurality of bonding portions in the circuit board 11, and uniformly heats the plurality of bonding portions in the circuit board 11. As a result, the timing to start melting is made substantially the same and the timing to end melting is made substantially the same for the solder sheets 33 arranged at the plurality of bonding portions, and efficiency of the soldering task is realized.
(9) The high frequency heating coils 28 are arranged outside to the container 17. This simplifies the structure for supporting the support plate 36, which supports the weights 35, with the cover body 19.
(10) When performing soldering on the circuit board 11 including the plurality of ceramic substrates 14, one high frequency heating coil 28 is arranged in association with each ceramic substrate 14 (weight 35) to heat the weight 35 on the ceramic substrate 14. This improves the efficiency in comparison to when heating the plurality of weights 35 respectively arranged on the plurality of ceramic substrates 14 with a single high frequency heating coil 28.
(11) The volume of the container 17 may be minimized to miniaturize the container 17 by arranging the high frequency heating coil 28 outside the container 17 and not inside the container 17. The atmosphere adjustment mainly includes the discharge of air from the container 17 (depressurization), the supply and discharge of inert gas (nitrogen gas etc.), and the supply and discharge of reductive gas (hydrogen etc.). Thus, when discharging air, reduction in the volume of the container 17 shortens the time required for the discharging and decreases the consumption of energy required for the discharging (e.g., energy necessary for operating the vacuum pump 25c). Further, when supplying or discharging inert gas or reductive gas, reduction in the volume of the container 17 shortens the time required for the supplying or discharging, decreases the consumption of energy required for the supplying or discharging, and decreases consumption of the supplied gas.
(12) The bonding portion of each metal circuit 13 is cooled by supplying cooling gas to the heat sink 15 attached to the ceramic substrate 14. Thus, the bonding portion of the metal circuit 13 is efficiently cooled by the heat sink 15, and the cooling time is shortened. This shortens the time related with the soldering.
   A second embodiment of the present invention will now be described with reference to Fig. 6. The second embodiment is basically the same as the first embodiment but differs in the structure of the weight 35. The similar portions will not be described in detail.
   In the embodiment, the weight 35 includes a passage 37. The passage 37 opens in the lower surface (pressurizing surfaces 35a) of the weight 35. The passage 37 enables negative pressure to act at the pressurizing surfaces 35a through its openings to attract the semiconductor elements 12 or the like to the pressurizing surface 35a. A connector 39 for connecting the passage 37 to a negative pressure source 38, which is located outside the container 17, is arranged on a surface of the weight 35 other than the lower surface. The passage 37 includes portions extending perpendicularly towards the plurality of pressurizing surfaces 35a of the weight 35. Each of these portions has a lower end that opens in the corresponding pressurizing surface 35a. The connector 39 is connected to the negative pressure source 38 by a flexible pipe 40, and a valve 40a is arranged in the pipe 40. The pipe 40 extends into the container 17 through the cover body 19. The valve 40a is switchable between a state communicating the connector 39 and the negative pressure source 38 and a state communicating the connector 39 and the atmosphere. That is, the valve 40a is operated to switch between a state in which negative pressure acts in the passage 37 and a state in which negative pressure does not act in the passage 37.
   When performing soldering with the use of the soldering device HK in this embodiment, the solder sheets 33 and the semiconductor elements 12 are arranged at positions corresponding to the holes 34 of each jig 32 placed on each ceramic substrate 14 by using the weight 35 as an attraction unit. When arranging the solder sheets 33 at positions corresponding to the holes 34, for example, the necessary number of solder sheets 33 are arranged outside the main body 18 in accordance with the layout of the solder sheets 33 on the circuit board 11. Then, the cover body 19 is positioned so that the pressurizing surfaces 35a of each weight 35 are aligned with the solder sheets 33. In this state, negative pressure is communicated from the negative pressure source 38 into the passage 37 of each weight 35. In a state in which the solder sheets 33 are attracted to the pressurizing surfaces 35a of each weight 35, the cover body 19 is moved to a position where it closes the opening 18a of the main body 18. In this state, the pressurizing surfaces 35a of each weight 35 are inserted into the holes 34 of the jig 32 with the attracted solder sheets 33, and the solder sheets 33 are arranged at positions corresponding to the bonding portion. Then, the communication of negative pressure to the passage 37 is stopped to cancel the attraction effect of the weight 35. Afterwards, the cover body 19 is removed from the main body 18. This places the solder sheets 33 on the bonding portion.
   Next, the necessary number of semiconductor elements 12 are arranged outside the main body 18 in accordance with the layout of the semiconductor elements 12 on the circuit board 11. Then, the cover body 19 is positioned so that the pressurizing surfaces 35a of each weight 35 are aligned with the semiconductor elements 12. In this state, negative pressure is communicated from the negative pressure source 38 into the passage 37 of each weight 35. This attracts the semiconductor elements 12 to the pressurizing surfaces 35a of each weight 35. Then, cover body 19 is attached to the main body 18. In this state, the pressurizing surfaces 35a of the weight 35 are inserted to the holes 34 of the jig 32 to place each semiconductor element 12 on the solder sheet 33, as shown in Fig. 6. The communication of negative pressure to the passage 37 is stopped to cancel the attraction effect by the weight 35. This completes the arrangement of the semiconductor elements 12 and weights 35 at the predetermined positions. Subsequently, soldering is performed in the same manner as in the first embodiment.
   Portions of the pipe 40 inside the container 17 are supported by supports (not shown) so that the load of the pipe 40 does not adversely affect the pressurizing effect of the weight 35. The weight of each weight 35 is set in view of the load applied by the pipe 40.
   In addition to advantages (1) to (12) of the first embodiment, the present embodiment has the advantages described below.
(13) Each weight 35 includes the passage 37, which has openings enabling the communication of negative pressure to attract the semiconductor elements 12 or the like to the pressurizing surfaces 35a. Further, the connector 39 for connecting the passage 37 to the negative pressure source 38 is arranged on the weight 35 at a surface other than the lower surface. Accordingly, the weight 35 is used as an attraction unit connected to the negative pressure source 38 through the connector 39. The plurality of semiconductor elements 12 or solder sheets 33 are attracted to the lower surface (pressurizing surfaces 35a) of the weight 35 and simultaneously arranged on the bonding portion (metal circuit 13).
(14) The negative pressure source 38 is arranged outside the container 17, and the pipe 40 extends into the container 17 through the cover body 19. Accordingly, the pipe 40 does not interfere with the removal of the cover body 19 from the main body 18 and the attachment of the cover body 19 to the main body 18.
   The embodiments are not limited in the manner described above and may be modified as described below.

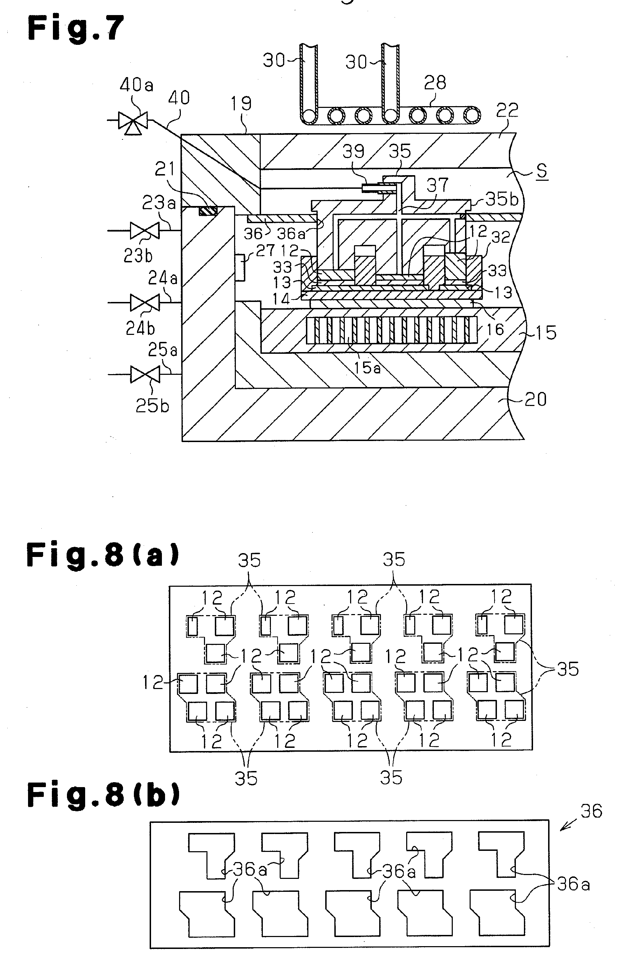

The layout, size, height, and the like of the semiconductor elements 12 are not limited in the manner described in the above embodiments. Referring to Fig. 7, a plurality of semiconductor elements 12 having different sizes and heights may be bonded to the ceramic substrate 14. Each weight 35 may be formed with dimensions enabling the weight 35 to extend over semiconductor elements (not shown) other than the three semiconductor elements shown in Fig. 7. This would obtain the same advantages as the second embodiment.

The weights 35 do not all have to be of the same size and shape. For example, as shown in Fig. 8(a), the plurality of semiconductor elements 12 may be divided into a plurality of groups, each including a different number of semiconductor elements 12 (in the illustrated example, a group including three semiconductor elements 12 and a group including four semiconductor elements 12), and the weights 35 (shown by double-dotted lines) may be shapes in correspondence with the layout of the semiconductor elements 12 in each group. In this case, two types of holes 36a are formed in the support plate 36 in correspondence with the shapes of the weights 35, as shown in Fig. 8(b).

Each weight 35 is not limited to an integrated component formed through milling and may be a weight 35 formed by joining a plurality of segments.

The support plate 36 for supporting the weights 35 does not have to be attached to the cover body 19 and may be independently movable from the cover body 19. In this case, a support member for supporting the support plate 36 is arranged in the main body 18. In a state in which the weights 35 are arranged on the semiconductor element 12, the support member preferably holds the support plate 36 so that the lower surface of the flange 35b on the weight 35 is spaced apart from the upper surface of the support plate 36.

When the cover body 19 is independently movable from the support plate 36, each weight 35 is used as an attraction unit by connecting the passage 37, which is formed in the weight 35, to the negative pressure source 38 through the pipe 40. In this case, the pipe 40 is removed after the weights 35 are arranged at predetermined positions on the corresponding semiconductor elements 12. As a result, the pipe 40 does not interfere with the attachment of the cover body 19 when arranging the cover body 19 at the closed position. Further, the pipe 40 does not adversely affect the orientation and the pressurizing effect of each weight 35.

Instead of simultaneously arranging all of the weights 35 at the predetermined positions, or positions over at least three semiconductor elements 12 that are laid out in a non-linear manner, the weights 35 may be arranged at the predetermined positions one at a time or in a certain number at a time. When arranging the weights 35 at the predetermined positions one at a time, the flange 35b (hook) is not necessary.

When moving the weights 35 in a state inserted into the hole 36a of the support plate 36, the structure for holding each weight 35 on the support plate 36 is not limited to the flange 35b. A plurality of projections may project from the upper side surface of each weight 35 to function as a hook.

The pressurizing surfaces 35a of each weight 35 does not need to have a size enabling contact with the entire non-bonding surfaces of the corresponding semiconductor elements 12 and may have larger or smaller sizes.

The jig 32 does not have to function to positioning function the solder sheets 33, the semiconductor elements 12, and the weight 35. The jig 32 may function to position only the solder sheets 33 and the semiconductor elements 12. In this case, the weight 35 is also arranged to extend over at least three of the semiconductor elements 12, which are laid out in a non-linear manner. This reduces variations in the thickness of the solder at the plurality of bonding portions compared to when pressurizing each semiconductor element 12 with a different weight.

When heating the weight 35 through induction heating and melting solder with the heat, the weight 35 does not have to be formed from stainless steel as long as it is formed from a material that can be induction heated. For example, iron or graphite may be used to form the weight 35. Alternatively, two types of conductive materials having different thermal conductivities may be used instead of stainless steel.

Instead of arranging the solder sheets 33 at locations corresponding to the bonding portions of the metal circuit 13, a solder paste may be applied to locations corresponding to the bonding portions.

The heating method for heating solder to a temperature higher than or equal to the melting point may be one other than induction heating. For example, an electric heater may be arranged in the container 17 to heat the solder.

The circuit board 11 may be formed so that the ceramic substrate 14 is integrated with a heat sink 15 that does not including the cooling medium passage 15a. Further, the circuit board 11 does not have to include the heat sink 15.

The cover body 19 may be fixed to the main body 18. For example, the cover body 19 may be connected to the main body 18 so that it can open and close.

It is preferable that at least a portion of the cover body 19 facing toward the high frequency heating coils 28 be formed from an electrically insulative material. Instead of glass, this portion may be formed from ceramics or a resin. Further, the cover body 19 may entirely be formed from the same electrically insulative material.

When the strength of the cover body 19 must be increased in accordance with the pressure difference between the inside and outside of the container 17, the cover body 19 may be formed from a complex material (GFRP (glass fiber reinforced plastics)) of glass fiber and resin. Further, the cover body 19 may be formed from metal. The metal is preferably a non-magnetic metal. If magnetic metal is used as the material for the cover body 19, it is preferred that a metal having a higher electrical resistivity than the weight 35 be used. The cover body 19 may be formed from complex material of metal and an insulative material. An electromagnetic steel plate etc. of ferromagnetic body may be used immediately above the weight 35 to effectively guide magnetic flux to the weight 35.

Each high frequency heating coil 28 may be arranged above the plurality of weights 35 so as to extend over the plurality of weights 35. In this case, the supply path of the high frequency current and the supply path of the cooling water to the high frequency heating coil 28 may be shortened, and the structure of the soldering device HK may be further simplified.

The container 17 may be movable along a production line, and the high frequency heating coil 28 may be arranged along the movement path of the weights 35, which move together with the container 17. In this case, the high frequency heating coil 28 may be shaped to extend along the movement path or may be arranged at plural locations along the movement path. In such a structure, the container 17 can be heated as it moves.

The high frequency heating coils 28 may be arranged so as to face toward the side surfaces of the weights 35.

The high frequency heating coils 28 may be arranged in the container 17 (sealed space S).

## Claims

1. A soldering method for soldering a semiconductor element to each of bonding portions defined at a plurality of locations on a circuit board, the soldering method comprising:
laying out the bonding portions in a non-linear manner in at least three locations on the circuit board;
placing the semiconductor elements on the bonding portions with solder in between;
placing a weight on the at least three semiconductor elements, which are laid out in a non-linear manner, so that the weight extends over the semiconductor elements; and
soldering the semiconductor elements to the bonding portions by melting the solder while pressurizing the semiconductor elements with the weight.

2. The soldering method according to claim 1, further comprising:
soldering the molten solder entirely over surfaces of the semiconductor elements facing toward the bonding portions.

3. The soldering method according to claim 1 or 2, wherein the circuit board is formed by fixing a ceramic insulator, which includes a surface with a metal circuit, to a metal heat sink, which includes a cooling medium passage.

4. The soldering method according to claim 1 or 2, wherein the circuit board is formed by fixing a plurality of ceramic insulators, which include surfaces with metal circuits, to a metal heat sink, which includes a cooling medium passage.

5. The soldering method according to claim 3 or 4, wherein the heat sink is formed from aluminum or copper.

6. The soldering method according to any one of claims 1 to 5, wherein the weight includes a passage, with the passage having openings respectively corresponding to the semiconductor elements in a pressurizing surface of the weight that is contactable with at least three semiconductor elements, and a connector enabling connection of the passage to a negative pressure source and arranged at a portion of the weight excluding the pressurizing surface, the method further comprising:
communicating negative pressure generated by the negative pressure source to the passage so as to attract at least three semiconductor elements to the pressurizing surface of the weight; and
moving the semiconductor elements to the bonding portions laid out in at least three locations in a non-linear manner in a state in which the semiconductor elements are attracted to the pressurizing surface.

7. The soldering method according to any one of claims 1 to 6, wherein the soldering is performed using a plurality of the weights in a sealable container including a main body and a cover body, with a support plate including a plurality of holes corresponding to the weights being attached to the cover body, the method further comprising:
moving the weights together with the cover body to the main body to attach the cover body to the main body in a state in which the weights are inserted into the corresponding holes and hooks arranged on the weights are hooked to an upper surface of the support plate, wherein When the cover body is attached to the main body, the weights are placed on the corresponding at least three semiconductor elements in a state in which the hook of each weight is separated from the upper surface of the support plate.

8. The soldering method according to any one of claims 1 to 7, further comprising:
heating the weight through an electromagnetic induction effect to melt the solder.

9. A semiconductor module manufacturing method including a circuit board, and a semiconductor element soldered to each of bonding portions defined at a plurality of locations on the circuit board, the manufacturing method comprising:
laying out the bonding portions in a non-linear manner in at least three locations on the circuit board;
placing the semiconductor elements on the bonding portions with solder in between;
placing a weight on the at least three semiconductor elements, which are laid out in a non-linear manner, so that the weight extends over the semiconductor elements; and
soldering the semiconductor elements to the bonding portions by melting the solder while pressurizing the semiconductor elements with the weight.

10. The manufacturing method according to claim 9, further comprising:
soldering the molten solder entirely over surfaces of the semiconductor elements facing toward the bonding portions.

11. The manufacturing method according to claim 9 or 10, further comprising:
forming the circuit board by fixing a ceramic insulator, which includes a surface with a metal circuit, to a metal heat sink, which includes a cooling medium passage.

12. The manufacturing method according to claim 9 or 10, further comprising:
forming the circuit board by fixing a plurality of ceramic insulators, which include surfaces with metal circuits, to a metal heat sink, which includes a cooling medium passage.

13. The manufacturing method according to claim 11 or 12, further comprising:
forming the heat sink from aluminum or copper.

14. The manufacturing method according to any one of claims 9 to 13, wherein the weight includes a passage, with the passage having openings respectively corresponding to the semiconductor elements in a pressurizing surface of the weight that is contactable with at least three semiconductor elements, and a connector enabling connection of the passage to a negative pressure source and arranged at a portion of the weight excluding the pressurizing surface, the method further comprising:
communicating negative pressure generated by the negative pressure source to the passage so as to attract at least three semiconductor elements to the pressurizing surface of the weight; and
moving the semiconductor elements to the bonding portions laid out in at least three locations in a non-linear manner in a state in which the semiconductor elements are attracted to the pressurizing surface.

15. The soldering method according to any one of claims 9 to 14, wherein the soldering is performed using a plurality of the weights in a sealable container including a main body and a cover body, with a support plate including a plurality of holes corresponding to the weights being attached to the cover body, the method further comprising:
moving the weights together with the cover body to the main body to attach the cover body to the main body in a state in which the weights are inserted into the corresponding holes and hooks arranged on the weights are hooked to an upper surface of the support plate, wherein when the cover body is attached to the main body, the weights are placed on the corresponding at least three semiconductor elements in a state in which the hook of each weight is separated from the upper surface of the support plate.

16. The manufacturing method according to any one of claims 9 to 15, further comprising:
heating the weight through an electromagnetic induction effect to melt the solder.
